Europäisches Patentamt

European Patent Office

Office européen des brevets

(19)

(11) Numéro de publication : **0 078 187**
**B1**

(12) **FASCICULE DE BREVET EUROPÉEN**

(45) Date de publication du fascicule du brevet :
11.02.87

(51) Int. Cl.⁴ : **H 03 D   9/06, H 03 D   7/14**

(21) Numéro de dépôt : **82401855.0**

(22) Date de dépôt : **08.10.82**

(54) **Dispositif mélangeur subharmonique hyperfréquence, et utilisation d'un tel dispositif dans un circuit hyperfréquence à transposition de fréquence.**

(30) Priorité : **23.10.81 FR 8119938**

(43) Date de publication de la demande :
**04.05.83 Bulletin 83/18**

(45) Mention de la délivrance du brevet :
**11.02.87 Bulletin 87/07**

(84) Etats contractants désignés :
**DE GB IT**

(56) Documents cités :
**IEEE TRANSACTIONS ON MICROWAVE THEORY AND TECHNIQUES, vol. MTT-28, no. 3, mars 1980, pages 180-185, New York (USA); H. OGAWA et al.: "K-Band integrated double-balanced mixer"**
**TELECOMMUNICATIONS & RADIO ENGINEERING, vol. 31-32, no. 6, juin 1977, pages 126-130, Washington (USA); YU.A.NEMLIKHER et al.: "Orthomodal type balanced varistor frequency converter"**
**PROCEEDINGS INTERNATIONAL MICROWAVE SYMPOSIUM, 12-14 mai 1975, IEEE 1975, pages 149-151, Piscataway (USA); L.E.DICKENS et al.: "A new "Phased-type" image enhanced mixer"**
**EDN ELECTRICAL DESIGN NEWS, vol. 19, no. 1, 5 janvier 1974, pages 56-60, Denver (USA); A.PODEL: "Use these latest techniques to improve your GHz circuits"**
**PATENTS ABSTRACTS OF JAPAN, vol. 5, no. 55, 16 avril 1981, pages 157 E 52;**
**IEEE TRANSACTIONS ON MICROWAVE THEORY AND TECHNIQUES, vol. MTT-23, no. 3, mars 1975, pages 271-275, New York (USA); M.V.SCHNEIDER et al.: "Harmonically pumped stripline down-converter"**

(73) Titulaire : **THOMSON-CSF**
**173, Boulevard Haussmann**
**F-75379 Paris Cedex 08 (FR)**

(72) Inventeur : **Houdart, Michel**
**THOMSON-CSF SCPI 173, bld Haussmann**
**F-75379 Paris Cedex 08 (FR)**

(74) Mandataire : **Benoît, Monique et al**
**THOMSON-CSF SCPI 19, avenue de Messine**
**F-75008 Paris (FR)**

EP 0 078 187 B1

## Description

La présente invention concerne un dispositif mélangeur subharmonique hyperfréquence et son utilisation dans un circuit hyperfréquence à transposition de fréquence.

Il est souvent nécessaire de transposer la fréquence $f_S$ d'un signal à une autre fréquence $f_{FI}$, dite fréquence intermédiaire. Les circuits mélangeurs alimentés par le signal de fréquence $f_S$ et par un oscillateur local de fréquence $f_{OL}$ délivrent un signal de fréquence fondamentale $f_{FI} = f_{OL} \pm f_S$.

Mais la réalisation de sources oscillateur local hyperfréquence stables est difficile ou onéreuse. Il est donc préférable d'utiliser, pour la transposition de fréquence, un mélangeur du type subharmonique, par exemple composé d'un doubleur de fréquence et d'un mélangeur classique, permettant d'utiliser un oscillateur local de fréquence moitié, plus facile à réaliser. Le principe d'un tel mélangeur subharmonique a été décrit par différents auteurs dans des articles tels que « Harmonically Pumped Stripline Down-Converter » de Martin V. Schneider et William W. Snell, paru dans IEEE Transactions on Microwave Theory and Techniques, pages 271-275, vol. MTT-23, N° 3, March 1975. Cet article décrit un mélangeur réalisé sur un substrat diélectrique pincé dans un guide d'onde rectangulaire et comprenant deux diodes Schottky montées tête-bêche à l'interconnexion de deux filtres ; un filtre passe-bande du côté signal incident $f_S$ et un filtre passe-bas du côté de l'entrée de l'oscillateur local $f_{OL}$ sur laquelle se fait également la sortie en fréquence intermédiaire. Le mode de découplage oscillateur local — signal incident et la technologie utilisée ne permettent d'envisager, pour le mélangeur décrit dans l'article mentionné ci-dessus, que des applications dans le cadre de systèmes à bande étroite limitée par les qualités du filtrage et les pertes existant dans les filtres.

La présente invention permet de remédier aux inconvénients ci-dessus mentionnés et a pour objet un mélangeur subharmonique équilibré à large bande particulièrement simple.

Un autre objet de la présente invention est la réalisation d'un mélangeur subharmonique équilibré dont les pertes de conversion sont minimisées.

Un autre objet de la présente invention est un mélangeur subharmonique équilibré présentant une bonne rejection des produits d'intermodulation secondaires et un bon découplage naturel des entrées oscillateur local et signal.

Le dispositif mélangeur subharmonique hyperfréquence selon l'invention comprenant un doubleur de fréquence et un mélangeur comportant des diodes Schottky, l'ensemble étant sur un même substrat et étant alimenté par un oscillateur local de fréquence $F_{OL}$ et un signal de fréquence $f_S$ et délivrant un signal à fréquence $f_{FI}$ tel que $f_{FI}$ soit une combinaison de ces signaux, est caractérisé en ce qu'il comprend :

— une première ligne coplanaire ayant un premier conducteur central encadré par un premier et un deuxième plan de masse, le conducteur central se divisant en un premier et un deuxième conducteur qui encadrent un deuxième conducteur central formant ainsi une deuxième et troisième ligne coplanaire constituant un diviseur équiphase ;

— une quatrième ligne coplanaire dont le conducteur central est dans le prolongement du deuxième conducteur central et dont les plans de masse sont dans le prolongement des premier et deuxième plans de masse constituant ainsi respectivement une première et une deuxième ligne à fente ;

— une première et une deuxième paire de diodes Schottky connectées à l'intersection des deuxième, troisième et quatrième lignes de manière à ce que la première diode de chacune des paires est respectivement connectée entre le premier, deuxième plan de masse et le premier et deuxième conducteurs, et de manière à ce que la deuxième diode de chacune des paires est respectivement connectée entre le premier, deuxième conducteur et le deuxième conducteur central ; le signal de l'oscillateur local alimentant la ligne coplanaire située à l'une des extrémités du dispositif et développant aux bornes de chaque diode Schottky une tension $V_{OL} = V_{OL} \cos 2\pi f_{OL}t$ du conducteur central vers chaque conducteur plan de masse ; le générateur délivrant le signal $f_S$ alimentant la ligne coplanaire située à l'autre extrémité du dispositif et développant aux bornes de chaque ligne à fente une tension $V'_S = 2V_S \cos 2\pi f_S t$ de sorte que le signal résultant ait une composante fondamentale correspondant à la fréquence intermédiaire :

$$f_{FI} = 2f_{OL} \pm f_S$$

ce signal $f_{FI}$ étant recueilli sur cette dernière ligne coplanaire.

La présente invention sera mieux comprise à la lecture de la description détaillée ci-après avec référence aux dessins ci-annexés qui représentent :

Figures 1a et 1b la structure d'une ligne de propagation à mode symétrique et d'une ligne de propagation à mode dissymétrique respectivement ;

Figure 2 le principe général d'un mélangeur hyperfréquence selon l'invention ;

Figure 3 un mélangeur unitaire sous-ensemble du mélangeur selon l'invention ;

Figure 4 un mode de réalisation du mélangeur hyperfréquence selon l'invention ;

Figure 5 une variante du mélangeur hyperfréquence de Fig. 4 ;

Figure 6 un autre mode de réalisation préférentiel du mélangeur hyperfréquence selon l'invention ;

et

Figure 7 l'excitation des éléments non linéaires du mode de réalisation de la fig. 6.

Dans le reste de la description, on désignera respectivement par $f_{OL}$, $f_S$, $f_{FI}$ la fréquence de l'oscillateur local, du signal incident et du signal de sortie à fréquence intermédiaire.

Dans un mélangeur dit subharmonique d'ordre 2, on cherche à travailler avec un signal oscillateur local de fréquence moitié de celle d'un oscillateur local utilisé dans un mélangeur classique et à obtenir en sortie un signal dont le terme fondamental ou fréquence intermédiaire est de la forme $f_{FI} = 2f_{OL} + f_S$ dans le cas d'un mélangeur du type « up-Converter » lorsque la fréquence intermédiaire est très supérieure à la fréquence du signal incident ; et de la forme $f_{FI} = |2f_{OL} - f_S|$ dans le cas d'un mélangeur du type « Down-Converter ».

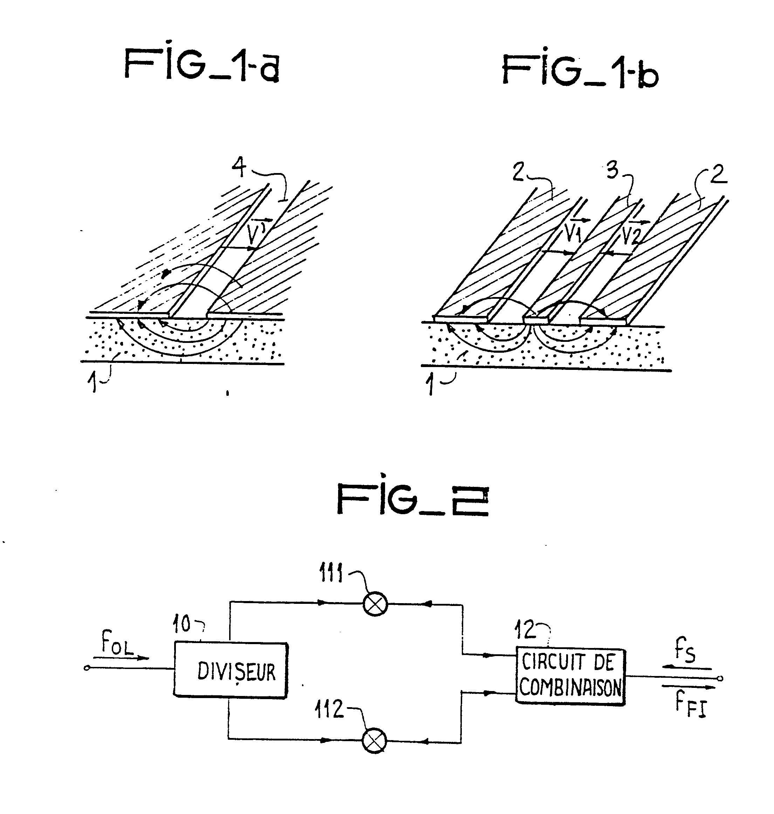

La figure 1a représente la structure d'une ligne de propagation symétrique du type à fente formée de deux conducteurs dessinant une fente 4 laissant apparaître le substrat 1 portant les deux conducteurs. Le vecteur V' représente la différence de potentiel développée aux bornes de la fente 4. La figure 1b représente la structure d'une ligne de propagation dissymétrique du type coplanaire portée par un substrat de matériau diélectrique 1 et comportant un conducteur 3 encadré par deux plans de masse 2. Les composantes du champ électrique sont symétriques par rapport au conducteur central 3 et la ligne coplanaire peut être considérée comme étant constituée de deux lignes à fente, telles que celle illustrée par la figure 1a. Les vecteurs $V_1$ et $V_2$ représentent la différence de potentiel sur chacune des lignes à fente.

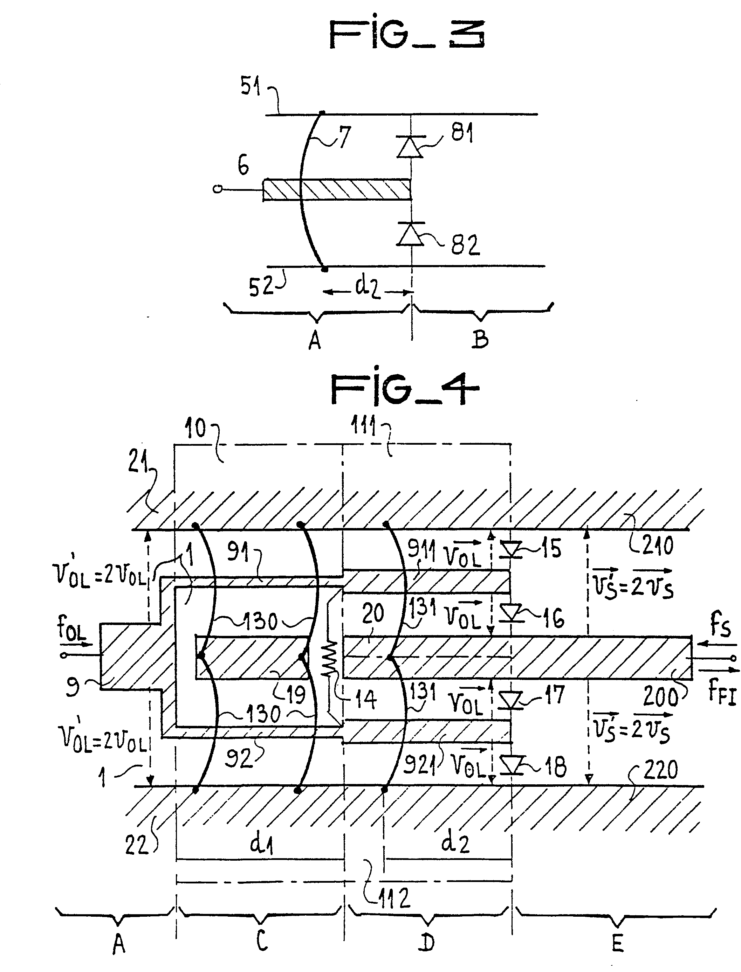

La figure 2 représente le principe général du mélangeur hyperfréquence selon l'invention. Il est constitué par l'association en parallèle d'un premier et d'un deuxième mélangeurs, dits unitaires 111 et 112 présentant une première entrée « signal incident » sur laquelle s'effectue également la sortie du signal à fréquence intermédiaire. Un premier circuit hyperfréquence 10 assure la division équiphase du signal « oscillateur local » en deux signaux destinés à alimenter la première entrée des premier et deuxième mélangeurs unitaires 111 et 112 respectivement. Un deuxième circuit hyperfréquence 12 alimenté par le signal incident $f_S$ sur une entrée à mode de propagation dissymétrique, délivre, sur deux accès ledit signal incident à la deuxième entrée de chacun des mélangeurs unitaires 111 et 112, et inversement reçoit sur chacun desdits accès un signal de même fréquence intermédiaire $f_{FI}$ délivré par chacun des deux mélangeurs unitaires 111 et 112 et les combine en un signal unique sur une sortie en mode dissymétrique. Ce circuit de combinaison permet de ramener en parallèle sur l'entrée « signal » $f_S$ de chacun des mélangeurs unitaires 111 et 112 une impédance la plus grande possible dans les bandes de fonctionnement des signaux de fréquence $f_S$ et $f_{FI}$.

Les mélangeurs unitaires 111 et 112, dont les entrées « signal » et « oscillateur local » présentent des structures de champ électrique de type différent symétrique et dissymétrique, comprennent chacun, selon une caractéristique connue de l'art antérieur, un couple d'éléments semi-conducteurs non linéaires qui peuvent selon un exemple non limitatif être des diodes Schottky.

La figure 3 représente le schéma d'un mélangeur unitaire constituant un sous-ensemble 111 ou 112 de la figure 2 décrite précédemment, et s'appliquant principalement dans le cas d'un mélangeur du type « up-converter ».

Les mélangeurs unitaires 111 et 112 de la figure 2 présentent la même structure et se composent comme on l'a déja mentionné d'une entrée « oscillateur local » à mode de propagation du type dissymétrique, par exemple coplanaire et d'une entrée « signal », à mode de propagation du type symétrique, par exemple ligne à fente, qui sert également de sortie à fréquence intermédiaire. Deux conducteurs 51 et 52, constituent pour la ligne coplanaire un plan de masse au potentiel de référence et encadrent le conducteur central 6. Les plans de masse de la ligne peuvent être dans le prolongement des conducteurs formant la ligne à fente. Les deux éléments semi-conducteurs non linéaires 81 et 82, constitués dans la figure 3 par des diodes Schottky de polarités opposées, sont disposés à l'intersection des deux lignes d'entrée et chargent respectivement chacune des deux lignes à propagation symétrique (51,6) et (6,52) constituant la ligne dissymétrique coplanaire. Un court-circuit 7 entre les conducteurs 51 et 52 est disposé sur la ligne dissymétrique coplanaire à une distance $d2 = (\lambda FI + \lambda S)/8$ en amont des diodes 81 et 82, $\lambda_S$ et $\lambda_{FI}$ étant la longueur d'onde moyenne de la bande de fréquence du signal incident et du signal de sortie à fréquence intermédiaire respectivement. La distance $d_2$ est choisie de façon telle que l'impédance ramenée au niveau des diodes est la plus élevée possible, à la fois dans la bande de fonctionnement du signal $f_S$ et de la fréquence intermédiaire $f_{FI}$.

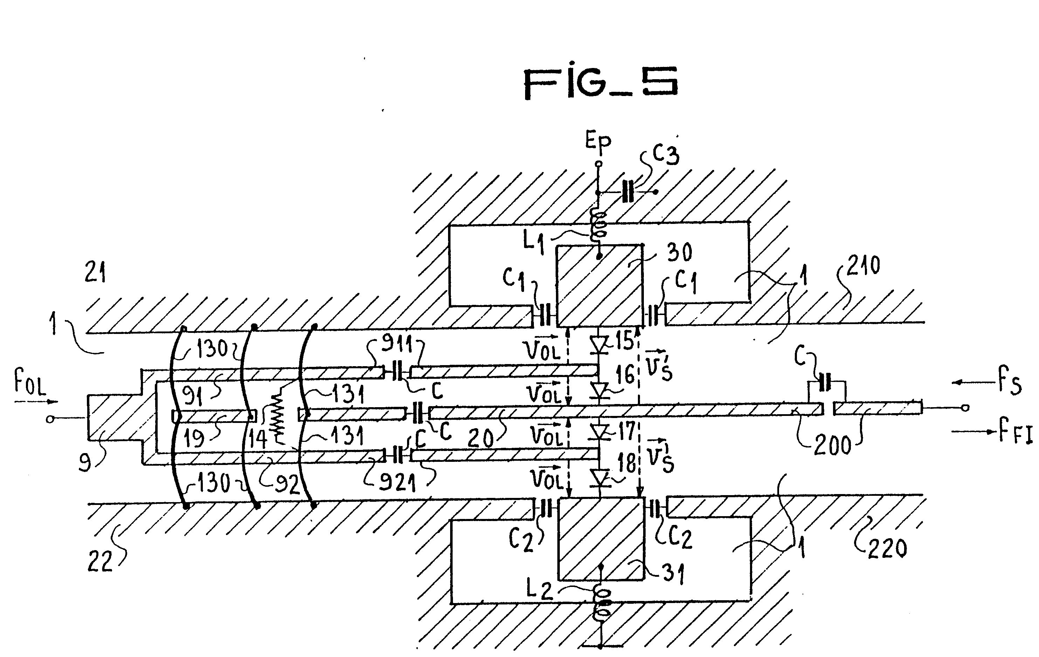

La figure 4 représente un mode de réalisation préférentiel non limitatif d'un mélangeur subharmonique s'appliquant préférentiellement au type « up-converter » réalisé sur un substrat de matériau diélectrique 1, le mélangeur se compose de quatre parties A, C, D, E.

La partie A formant l'entrée « oscillateur local » du mélangeur est du type dissymétrique et est constituée dans l'exemple de la figure 4 par une ligne coplanaire. Cette ligne coplanaire d'entrée comprend un conducteur central 9 encadré par deux conducteurs 21 et 22, formant plans de masse. Le conducteur central 9 se partage en deux conducteurs 91 et 92 encadrant un plan de masse 19 rendu équipotentiel avec les conducteurs 21 et 22 formant plans de masse grâce aux courts-circuits 130. Le conducteur 91, respectivement 92, forme avec les plans de masse 21, respectivement 22, et 19 une ligne coplanaire.

Les deux lignes coplanaires ainsi formées sont les deux branches d'un circuit diviseur équiphase désigné par les références 10 dans la figure 2 et C dans la figure 4 et constituent dans le mode de réalisation de la figure 4, un Té de Wilkinson. Les extrémités des conducteurs centraux 91 et 92 sont raccordés par l'intermédiaire de la résistance d'adaptation 14, à la distance $d_1 = \lambda_{OL}/4$, du conducteur central 9, $\lambda_{OL}$ étant la longueur d'onde moyenne de la bande de fréquence de l'oscillateur local du mélangeur. Dans le mode de réalisation de la figure 4, le Té de Wilkinson comprend un seul tronçon de longueur $d_1$.

Pour augmenter la largeur de bande du mélangeur sur l'entrée « oscillateur local », on peut utiliser de façon avantageuse un Té de Wilkinson constitué de plusieurs tronçons de ligne de longueur $d_1 = \lambda_{OL}/4$ associés à plusieurs résistances d'adaptation.

Dans le mode de réalisation de la figure 4, les mélangeurs hyperfréquence unitaires, désignés respectivement par les références 111 et 112 dans le schéma de principe de la figure 2, comprennent chacun une partie coplanaire D et une partie formant ligne à fente E. La ligne coplanaire D est constituée, pour chaque mélangeur 111, respectivement 112, en plus du conducteur 21, respectivement 22, formant le premier plan de masse, d'un conducteur central 911, respectivement 921, prolongeant le conducteur central 91, respectivement 92, de la branche correspondante du Té diviseur C. Entre ces deux conducteurs 911 et 921, un conducteur 20, commun aux deux mélangeurs unitaires, forme le deuxième plan de masse. La partie ligne à fente E est constituée par les conducteurs 210, respectivement 220, et 200. A la jonction de la ligne coplanaire D et de la ligne à fente E, une paire de diodes Schottky 15, 16, respectivement 17, 18, est disposée comme illustré par la figure 3. Les diodes 15 et 16, respectivement 17 et 18, de chaque paire présentent des polarités opposées et sont placées entre les conducteurs 21 et 911, 911 et 20, respectivement 20 et 921, 921 et 22, les deux paires étant disposées tête-bêche. Les conducteurs 210 et 200, respectivement 200 et 220, prolongeant ou non les conducteurs 21 et 20, respectivement 20 et 22, forment une ligne à fente si l'on considère chaque circuit séparément. Mais ces mêmes conducteurs 210, 200, 220 pris dans leur ensemble, constituent une ligne coplanaire et par conséquent une ligne de propagation du type dissymétrique servant à la fois de ligne d'entrée pour le signal hyperfréquence incident et de ligne de sortie pour le signal à fréquence intermédiaire.

Le circuit dit de combinaison comprend également des courts-circuits 131 entre les conducteurs 21, 20 et 22 disposés sur les lignes coplanaires D des mélangeurs unitaires 111 et 112, à une distance $d_2 = (\lambda FI + \lambda S)/8$ en amont des diodes Schottky 15, 16, 17, 18 telle que l'impédance ramenée au niveau des diodes soit la plus élevée possible dans la bande de fonctionnement du signal et de la fréquence intermédiaire. Mais la distance $d_2$ doit être suffisamment grande pour que lesdits courts-circuits 131 ne viennent pas court-circuiter les diodes Schottky. Ceci élimine par conséquent l'utilisation en « Down Converter » du mélangeur de la figure 4 dans le cas où la fréquence FI est particulièrement basse.

Le principe de fonctionnement du mélangeur selon l'invention est le suivant :

On suppose que l'oscillateur local alimente avec une tension $v'_{OL} = 2V_{OL}\cos 2\pi f_{OL}t$ la ligne coplanaire A et développe, aux bornes de chaque diode Schottky, une tension de la forme $v_{OL} = V_{OL}\cos 2\pi f_{OL}t$.

De même, on suppose que le générateur délivrant le signal incident développe aux bornes de chaque ligne à fente constituant la ligne coplanaire E d'entrée du signal une tension de la forme $v'_S = 2V_S\cos 2\pi f_S t$ donc aux bornes de chaque diode une tension $v_S = v'/2 = V_S\cos 2\pi f_S t$. La caractéristique de la diode Schottky peut être approchée par la relation $i_i = I_s(e^{\alpha vi} - 1)$ où $i_i$ est le courant circulant dans la diode, $v_i$ est la tension développée à ses bornes, un coefficient dépendant de la température absolue et dont la dimension est l'inverse d'une tension, et $I_s$ le courant de saturation de la diode.

Soit $i_1$, $i_2$, $i_3$ et $i_4$ le courant circulant respectivement dans les diodes 15, 16, 17 et 18. On suppose que les diodes présentent un même courant de saturation $I_s$.

Le courant $i = i_1 + i_2 - i_3 - i_4$ à fréquence intermédiaire circulant dans le conducteur central 200 en sortie du mélangeur est donc égal à :

$$i_1 = I_s[\exp\{\alpha(v_S + v_{OL})\} - 1]$$
$$i_2 = I_s[\exp\{\alpha(v_S - v_{OL})\} - 1]$$
$$i_3 = I_s[\exp\{\alpha(-v_S + v_{OL})\} - 1]$$
$$i_4 = I_s[\exp\{\alpha(-v_S - v_{OL})\} - 1]$$
$$i = I_s[\exp(\alpha v_S) - \exp(-\alpha v_S)\exp(\alpha v_{OL}) + \exp(\alpha - v_{OL})].$$

Soit $i = 4I_s\,\text{ch}(V_{OL}\cos 2\pi f_{OL}t)\text{sh}(V_S\cos 2\pi f_S t)$.

La décomposition en série de Fourier donne :

$$i = \sum_k I_k \cos 2\pi[2\,nf_{OL}\,t \pm (2m + 1)\,f_S\,t].$$

Le dispositif délivre donc un signal duquel les composantes correspondant aux harmoniques pairs du signal incident sont exclues. De plus d'après la théorie des fonctions de Bessel, le niveau de l'harmonique $2f_{OL} \mp f_S$ est très supérieur à celui des autres harmoniques. Ceci équivaut pratiquement à une réjection au profit de l'harmonique $2f_{OL} \mp f_S$. Le dispositif de la figure 4 est donc bien un mélangeur subharmonique.

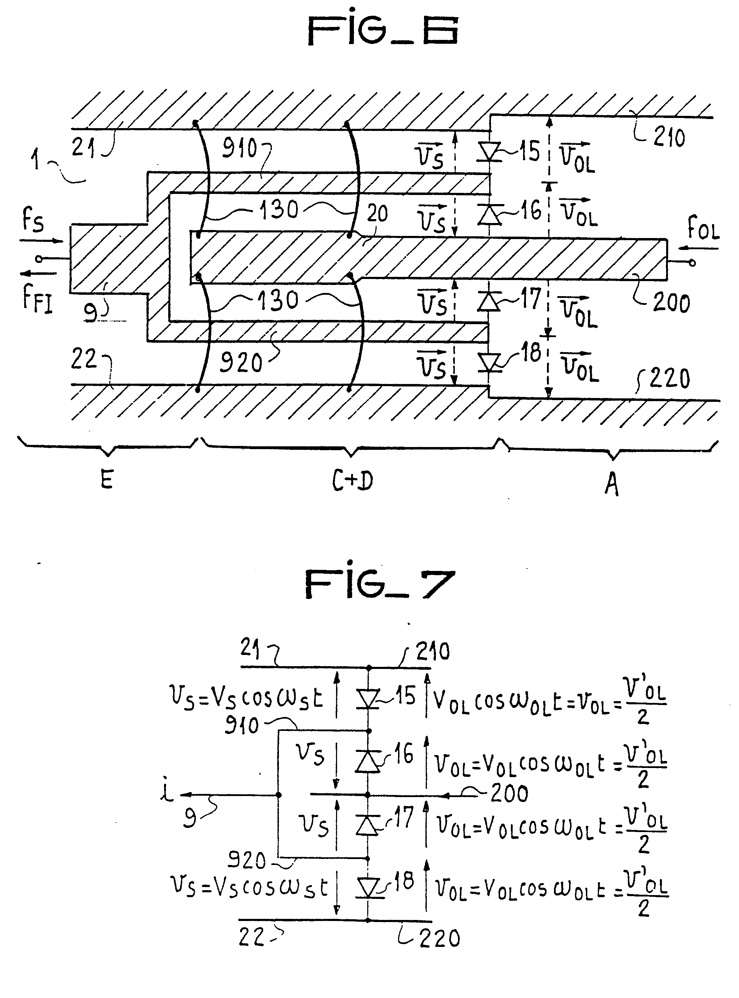

La figure 5 représente un autre mode de réalisation préférentiel du mélangeur subharmonique selon l'invention.

Le rendement de conversion dépend dans une grande mesure du niveau du signal oscillateur local. Dans le cas d'un oscillateur local présentant un niveau faible, il est nécessaire d'introduire une tension continue de polarisation en série avec chaque diode Schottky et de trouver un compromis entre la tension de polarisation et la tension de l'oscillateur local pour obtenir une bonne linéarité et par conséquent un bon rendement de conversion. Le mélangeur subharmonique obtenu, représenté par la figure 5, peut également fonctionner en « Down-Converter » dans lequel la fréquence intermédiaire $f_{FI} = |2f_{OL} - f_s|$ peut être très basse et nécessiter l'introduction d'une tension de polarisation.

Le mélangeur représenté sur la figure 5 est une variante de celui qui est représenté sur la figure 4. Les mêmes éléments, portant les mêmes références, ont donc été repris sur la figure 5. Le courant de polarisation est introduit par l'entrée $E_p$, isolée du plan de masse 21 par une capacité C3, traverse l'inductance de choc L1 et le conducteur 30 raccordé au plan de masse 21 par l'intermédiaire des capacités $C_1$. Les diodes 15, 16, 17, 18 présentent la même disposition que dans la figure 4 mais entre les conducteurs 30 et 911, 911 et 20, 20 et 921, 921 et 31, le conducteur 31 étant raccordé au plan de masse 22 par l'intermédiaire des capacités $C_2$. Le courant de polarisation traverse ensuite l'inductance de choc L2 reliant le conducteur 31 au plan de masse 22.

Les conducteurs 20, 911, 921 sont chacun constitués de plusieurs tronçons interconnectés par des capacités série C.

Les valeurs des capacités C, C1, C2 sont choisies de façon à constituer des courts-circuits dans les bandes de fréquence de l'oscillateur local, du signal incident et du signal de sortie à fréquence intermédiaire. Leur impédance est infinie pour le courant continu. Inversement les inductances L1 et L2 constituent des courts-circuits pour le courant continu.

Les quatre diodes Schottky sont donc bien polarisées par la tension continue appliquée en $E_p$.

La largeur de bande du dispositif des figures 4 et 5 est limitée par plusieurs facteurs :

— Les possibilités d'adaptation des différentes entrées et sorties liées d'une part à la technologie utilisée pour les surfaces conductrices et d'autre part à la qualité des éléments semiconducteurs utilisés, et en particulier à la capacité des diodes Schottky.

— La définition du circuit de combinaison qui ramène en parallèle sur chacun des couples de diodes une impédance purement réactive maximum dans les bandes de fréquences du signal incident et du signal de sortie à fréquence intermédiaire.

— La largeur de bande du circuit diviseur d'oscillateur local.

La figure 6 représente un autre mode de réalisation préférentiel du mélangeur subharmonique selon l'invention. Le mélangeur ainsi conçu peut fonctionner en « up-converter » ou « down-converter ».

Sur un substrat de matériau diélectrique 1, deux conducteurs 21 et 22 forment plans de masse. Entre ces deux conducteurs 21, 22 est disposé un conducteur central 9 qui se partage en deux branches 910 et 920, de même longueur d, également disposées entre les deux conducteurs 21, 22 formant plan de masse et séparées par un troisième conducteur 20 formant plan de masse et rendu équipotentiel avec les premier et deuxième plans de masse à l'aide de courts-circuits 130. A l'extrémité des conducteurs 910 et 920, deux couples de diodes Schottky de même sens 15, 16 et 17, 18 sont disposés tête-bêche, chaque diode raccordant un conducteur formant plan de masse et un conducteur central.

Dans le cas de la figure 6, les diodes 15, 16, 17, 18 sont respectivement dirigées du premier conducteur 21, formant plan de masse, vers la première branche 910, du troisième conducteur 20 formant plan de masse vers la première branche 910, de la deuxième branche 920 vers le conducteur 20 formant plan de masse, pour la diode 17, et vers le conducteur 21 formant plan de masse, pour la diode 18. Les deux conducteurs 210, 220 formant plan de masse et le conducteur 200 qu'ils encadrent constituent une ligne coplanaire utilisée comme ligne d'entrée du dispositif pour l'oscillateur local, alors que la ligne coplanaire formée des deux plans de masse 21, 22 encadrant le conducteur central 9 constitue à la fois la deuxième ligne d'entrée du dispositif pour le signal incident et la ligne de sortie à fréquence intermédiaire. Le circuit diviseur utilisé dans le mode de réalisation de la figure 6 est une simple jonction en Té. Les conducteurs 200, 210 et 220 peuvent prolonger les conducteurs 20, 21 et 22 respectivement.

Le dispositif représenté sur la figure 6 fonctionne de la façon suivante, comme illustré dans la figure 7 :

On suppose que l'oscillateur local alimentant la ligne coplanaire A développe, aux bornes de chaque ligne à fente (210, 200) et (200, 220) constitutive une tension de la forme

$$v'_{OL} = 2V_{OL}\cos 2\pi f_{OL}t,$$

du conducteur central 200 vers chaque conducteur formant plan de masse 210, 220.

La tension développée aux bornes de chaque diode est donc égale à :

$$v_{OL} = v'_{OL}/2 = V_{OL}\cos 2\pi f_{OL}t.$$

**0 078 187**

De même on suppose que le générateur délivrant le signal incident appliqué à l'entrée de la ligne coplanaire E formée par les conducteurs 21, 9, 22 développe aux bornes de chaque diode Schottky 15, 16, 17, 18 une tension de la forme $v_s = V_S \cos 2\pi f_S t$ du conducteur central 910 ou 920 vers le conducteur formant plan de masse 21, 20 ou 22.

Dans le mode de réalisation des figures 6 et 7, les diodes 15, 16, 17, 18 présentent par conséquent à leurs bornes une tension respective totale $v_1$, $v_2$, $v_3$, $v_4$ égale à :

$$v_1 = v_S + v_{OL}$$
$$v_2 = v_S - v_{OL}$$
$$v_3 = v_{OL} - v_S$$
$$v_4 = - v_S - v_{OL}$$

étant donné le sens de la tension développée par le signal incident ou l'oscillateur local par rapport au sens de la diode.

Comme on l'a déjà mentionné plus haut pour expliquer le fonctionnement du mode de réalisation de la figure 4, le courant circulant dans chaque diode peut être approché par la relation :

$$i_i = I_s [\exp(\alpha v_{i-1})] \, .$$

Si l'on suppose que les quatre diodes 15, 16, 17, 18 présentent un même courant de saturation Is, i prenant la valeur respective 1, 2, 3, 4 pour chaque diode 15, 16, 17, 18 respectivement, le courant de sortie i dans le conducteur central 9 est égal à $i = i_1 + i_2 - i_3 - i_4$ étant donné la disposition des diodes dans le mode de réalisation de la figure 6.

On se retrouve par conséquent dans le même cas que pour le mode de réalisation de la figure 4. Après décomposition en série de Fourier, on obtient de la même façon un courant de sortie égal à :

$$i = \sum_k I_k \cos 2\pi [2 \, p f_{OL} \, t \pm (2 \, q + 1) \, f_s \, t]$$

duquel sont également absentes les composantes correspondant aux harmoniques d'ordre pair du signal incident.

De la même façon le niveau des composantes $|2f_{OL} \pm f_S|$, très supérieur à celui des autres composantes traduit une réjection des autres composantes au profit de la composante fondamentale $|2f_{OL} \pm f_S|$.

Le dispositif représenté par la figure 6 est donc bien un mélangeur subharmonique au type « Dual » c'est-à-dire ne présentant pas l'inconvénient des modes de réalisation des figures 4 et 5 particulièrement adaptés au fonctionnement en « up converter » et en « down-converter » respectivement. De plus la conception en est particulièrement simple. En effet le diviseur 10 et le circuit de combinaison 12 de la figure sont constitués par un seul et même circuit entre la ligne coplanaire 21, 9, 22 d'entrée du signal incident et de sortie du signal à fréquence intermédiaire et les diodes Schottky. D'autre part, lesdites diodes Schottky assurent la charge de chacune des branches du diviseur. L'isolement entre voies comme dans le cas des figures 4 et 5 n'est plus nécessaire. Enfin, le signal à fréquence intermédiaire circule, non plus du côté ligne à fente comme dans les figures 4 et 5, mais du côté coplanaire des mélangeurs unitaires tels que définis dans la figure 2. Alors que dans le cas des figures 4 et 5, les courts-circuits 131 à la distance d2 des diodes permettaient de ramener l'impédance la plus élevée possible dans la bande de fonctionnement du signal et dans celle du signal de sortie à fréquence intermédiaire, ces courts-circuits 131 se trouvent supprimés de par la conception du circuit de combinaison et de la ligne de sortie à fréquence intermédiaire. L'obstacle à un fonctionnement du type dual présenté par les modes de réalisation des figures 4 et 5 est donc levé.

Dans le cas d'une symétrie parfaite du système selon les figures 4, 5 ou 6, on obtient naturellement un découplage infini entre les entrées « signal » et « oscillateur local ».

Il conviendra à l'homme de l'art de déterminer de façon optimale les largeurs et longueurs des différentes zones conductrices pour que la bande de fréquences d'utilisation du système soit la plus large possible.

Il est bien entendu possible d'associer deux mélangeurs subharmoniques selon l'invention afin d'obtenir un mélangeur à rejection d'image.

La présente invention est applicable aux circuits hyperfréquence nécessitant une transposition de fréquence.

**Revendications**

1. Dispositif mélangeur subharmonique hyperfréquence comprenant un doubleur de fréquence et un mélangeur comportant des diodes Schottky, l'ensemble étant sur un même substrat et étant alimenté par un oscillateur local de fréquence $F_{OL}$ et un signal de fréquence $f_S$ et délivrant un signal à fréquence $f_{FI}$

tel que $f_{FI}$ soit une combinaison de ces signaux, caractérisé en ce qu'il comprend :

— une première ligne coplanaire (9, 21, 22) ayant un premier conducteur central (9) encadré par un premier (21) et un deuxième (22) plan de masse, le conducteur central se divisant en un premier (910) et un deuxième (920) conducteur qui encadrent un deuxième conducteur central (20) formant ainsi une deuxième (21, 910, 20) et troisième (22, 920, 20) ligne coplanaire constituant un diviseur équiphase ;

— une quatrième ligne coplanaire (200, 210, 220) dont le conducteur central (200) est dans le prolongement du deuxième conducteur central (20) et dont les plans de masse (210, 220) sont dans le prolongement des premier (21) et deuxième (22) plans de masse constituant ainsi respectivement une première (200, 210) et une deuxième (200, 220) ligne à fente ;

— une première (15, 16) et une deuxième (17, 18) paire de diodes Schottky connectées à l'intersection des deuxième, troisième et quatrième lignes de manière à ce que la première (15 ou 18) diode de chacune des paires est respectivement connectée entre le premier (21), deuxième (22) plan de masse et le premier (910) et deuxième (920) conducteurs, et de manière à ce que la deuxième (16 ou 17) diode de chacune des paires est respectivement connectée entre le premier (910), deuxième (920) conducteur et le deuxième (200) conducteur central ; le signal de l'oscillateur local alimentant la ligne coplanaire située à l'une des extrémités du dispositif et développant aux bornes de chaque diode Schottky une tension $V_{OL} = V_{OL} \cos 2\pi f_{OL} t$ du conducteur central vers chaque conducteur plan de masse ; le générateur délivrant le signal $f_S$ alimentant la ligne coplanaire située à l'autre extrémité du dispositif et développant aux bornes de chaque ligne à fente une tension $V'_S = 2 V_S \cos 2\pi f_S t$ de sorte que le signal résultant ait une composante fondamentale correspondant à la fréquence intermédiaire :

$$f_{FI} = 2 f_{OL} \pm f_S$$

ce signal $f_{FI}$ étant recueilli sur cette dernière ligne coplanaire.

2. Dispositif selon la revendication 1, caractérisé en ce que le diviseur équiphase (910, 920, 20) comporte un ou plusieurs tronçons de longueur $\lambda_{OL}/4$, où $\lambda_{OL}$ est la longueur d'onde correspondant à la fréquence $f_{OL}$ de l'oscillateur local.

3. Dispositif selon la revendication 1 ou 2, caractérisé en ce que les premiers (21) et deuxièmes (22) plans de masse sont raccordés directement au deuxième conducteur central (20) par des courts-circuits (130).

4. Dispositif selon l'une quelconque des revendications 1 à 3, caractérisé en ce que l'extrémité du premier conducteur central (9) constitue une entrée pour le signal à la fréquence $f_S$ et une sortie pour le signal à la fréquence $f_{FI}$, l'extrémité côté ligne à la fente du deuxième conducteur central (200) constitue une entrée pour le signal à fréquence $f_{OL}$ ; la première paire de diode (15, 16) étant connectée tête-bêche, leur cathode étant connectée au premier conducteur (910) ; la deuxième paire (17, 18) étant connectée tête-bêche, leur anode étant connectée au deuxième conducteur (920).

5. Dispositif selon l'une quelconque des revendications 1 à 3, caractérisé en ce que l'extrémité du premier conducteur central (9) constitue une entrée pour le signal à la fréquence $f_{OL}$, l'extrémité côté ligne à fente du deuxième conducteur central (200) constitue une entrée pour le signal à la fréquence $f_S$ et une sortie à la fréquence $f_{FI}$ ; les diodes de la première paire (15, 16) étant connectées dans le même sens, l'anode de la première diode étant reliée au premier plan de masse (21), les diodes de la deuxième paire (17, 18) étant connectées dans le même sens, la cathode de la deuxième diode étant reliée au deuxième plan de masse (22) et en ce qu'un court-circuit (131) placé à une distance $d_2 = (\lambda_S + \lambda_{FI})/8$ des diodes, relie les premiers (21) et deuxièmes (22) plans de masse directement au deuxième conducteur central (20).

## Claims

1. Subharmonic hyperfrequency mixer device comprising a frequency doubler and a mixer having Schottky diodes, the unit being on the same substrate and being fed by a local oscillator of the frequency $F_{OL}$ and a signal of the frequency $f_S$, and supplying a signal of the frequency $f_{FI}$ such that $f_{FI}$ is a combination of these signals, characterized in that it comprises :

— a first coplanar line (9, 21, 22) having a first central conductor (9) framed by a first (21) and a second (22) ground plane, the central conductor being divided into a first (910) and a second (920) conductor which frame a second central conductor (20) thus forming second (21, 910, 20) and third (22, 920, 20) coplanar lines forming an equiphase divider ;

— a fourth coplanar line (200, 210, 220) the central conductor (200) of which is in the extension of the second central conductor (20) and the ground planes (210, 220) of which are in the extension of the first (21) and second (22) ground planes thus respectively forming a first (200, 210) and a second (200, 220) slot line ;

— a first (15, 16) and a second (17, 18) pair of Schottky diodes connected at the intersection of the second, third and fourth lines in such a manner that the first (15 or 18) diode of each of the pairs is respectively connected between the first (21) or second (22) ground plane and the first (910) or second (920) conductors, and in such a manner that the second (16 or 17) diode of each pair is respectively connected between the first (910) or second (920) conductor and the second (200) central conductor ; the signal of the local oscillator feeding the coplanar line located at one of the ends of the device and developing at the terminal of each Schottky diode a voltage $V_{OL} = V_{OL} \cos 2\pi f_{OL} t$ of the central conductor to each plane ground conductor ; the generator supplying the signal $f_S$ feeding the coplanar line located at the other end of the device and developing at the terminal of each slot line a voltage $V'_S = 2V_S \cos 2\pi f_s t$, in such a manner that the resulting signal has a fundamental component corresponding to the intermediate frequency :

$$f_{FI} = 2 f_{OL} \pm f_S$$

this signal $f_{FI}$ being obtained on the latter coplanar line.

2. Device according to claim 1, characterized in that the equiphase divider (910, 920, 20) comprises one or a plurality of sections of the length $\lambda_{OL}/4$, wherein $\lambda_{OL}$ is the wavelength corresponding to the frequency $f_{OL}$ of the local oscillator.

3. Device according to claim 1 or 2, characterized in that the first (21) and second (22) ground planes are directly connected by short-circuits (130) to the second central conductor (20).

4. Device according to any of claims 1 to 3, characterized in that the end of the first central conductor (9) forms an input for the signal of the frequency $f_S$ and an output for the signal of the frequency $f_{FI}$, the end of the second central conductor (20) located on the side of the slot line forming an input for the signal of the frequency $f_{OL}$ ; the first pair of diodes (15, 16) being connected in mutually inverted orientation, their cathodes being connected to the first conductor (910) ; the second pair (17, 18) being connected in mutually inverted orientation, their anodes being connected to the second conductor (920).

5. Device according to any of claims 1 to 3, characterized in that the end of the first central conductor (9) forms an input for the signal of the frequency $f_{OL}$, the end of the second central conductor (200) located on the side of the slot line forming an input for the signal of the frequency $f_S$ and an output at the frequency $f_{FI}$ ; the diodes of the first pair (15, 16) being connected in similar orientation, the anode of the first diode being connected to the first ground plane (21), the diode of the second pair (17, 18) being connected in the same sense, the cathode of the second diode being connected to the second ground plane (22), and in that a short-circuit (131) located at a distance $d_2 = (\lambda_S + \lambda_{FI})/8$ of the diodes connecting the first (21) and second (22) ground planes directly with the second central conductor (20).


**Patentansprüche**

1. Subharmonische Mikrowellen-Mischvorrichtung mit einem Frequenzverdoppler und einem Mischer, welcher Schottky-Dioden enthält, wobei die gesamte Baugruppe auf demselben Substrat angeordnet ist und durch einen Lokaloszillator der Frequenz $F_{OL}$ sowie ein Signal der Frequenz $f_S$ gespeist wird und ein Signal der Frequenz $f_{FI}$ dergestalt, daß $f_{FI}$ eine Kombination dieser Signale ist, abgibt, dadurch gekennzeichnet, daß sie umfaßt :
— eine erste koplanare Leitung (9, 21, 22) mit einem ersten zentralen Leiter (9), der von einer ersten (21) und einer zweiten (22) Masseebene eingerahmt wird, wobei der zentrale Leiter in einem ersten (910) und einen zweiten (920) Leiter unterteilt ist, welche einen zweiten zentralen Leiter (20) einrahmen, so daß eine zweite (21, 910, 20) und eine dritte (22, 920, 20) koplanare Leitung gebildet wird, die einen gleichphasigen Teiler darstellen ;
— eine vierte koplanare Leitung (200, 210, 220), deren zentraler Leiter (200) sich in der Verlängerung des zweiten zentralen Leiters (20) befindet und wovon die Masseebenen (210, 220) sich in der Verlängerung der ersten (21) und der zweiten (22) Masseebene befinden, so daß jeweils eine erste (200, 210) bzw. eine zweite (200, 220) Schlitzleitung gebildet ist ;
— ein erstes (15, 16) und ein zweites (17, 18) Schottky-Diodenpaar, welche an der Schnittstelle der zweiten, dritten und vierten Leitung derart angeschlossen sind, daß die erste Diode (15 oder 18) jedes Paares jeweils zwischen die erste (21) bzw. zweite (22) Masseebene und den ersten (910) bzw. zweiten (920) Leiter geschaltet ist, sowie dergestalt, daß die zweite (16 oder 17) Diode jedes Paares jeweils zwischen den ersten (910) bzw. zweiten (920) Leiter und den zweiten (200) zentralen Leiter geschaltet ist ; wobei das Signal des Lokaloszillators die koplanare Leitung speist, die an einem der Enden der Vorrichtung angeordnet ist, und an den Anschlüssen jeder Schottky-Diode eine Spannung $V_{OL} = V_{OL} \cos 2\pi f_{OL} t$ des zentralen Leiters zu jedem Masseebenenleiter erzeugt ; wobei der Generator das Signal $f_S$ abgibt, welches die koplanare Leitung speist, die am anderen Ende der Vorrichtung liegt, und an den Anschlüssen jeder Schlitzleitung eine Spannung $V'_S = 2 V_S \cos 2\pi f_s t$ erzeugt, dergestalt, daß das resultierende Signal eine Grundkomponente aufweist, die der Zwischenfrequenz entspricht :

$$f_{FI} = 2 f_{OL} \pm f_{S},$$

wobei dieses Signal $f_{FI}$ an dieser letzteren koplanaren Leitung abgenommen wird.

2. Vorrichtung nach Anspruch 1, dadurch gekennzeichnet, daß der gleichphasige Teiler (910, 920, 20) einen oder mehrere Abschnitte der Länge $\lambda_{OL}/4$ aufweist, worin $\lambda_{OL}$ die Wellenlänge ist, welche der Frequenz $f_{OL}$ des Lokaloszillators entspricht.

3. Vorrichtung nach Anspruch 1 oder 2, dadurch gekennzeichnet, daß die erste (21) und die zweite (22) Masseebene direkt an den zweiten zentralen Leiter (20) über Kurzschlüsse (130) angeschlossen sind.

4. Vorrichtung nach einem der Ansprüche 1 bis 3, dadurch gekennzeichnet, daß das Ende des ersten zentralen Leiters (9) einen Eingang für das Signal der Frequenz $f_S$ und einen Ausgang für das Signal der Frequenz $f_{FI}$ bildet, wobei das auf der Seite der Schlitzleitung liegende Ende des zweiten zentralen Leiters (200) einen Eingang für das Signal der Frequenz $f_{OL}$ bildet ; wobei das erste Diodenpaar (15, 16) entgegengesetzt gepolt geschaltet ist, wobei die Kathoden mit dem ersten Leiter (910) verbunden sind ; wobei das zweite Diodenpaar (17, 18) entgegengesetzt gepolt geschaltet ist und die Anoden mit dem zweiten Leiter (920) verbunden sind.

5. Vorrichtung nach einem der Ansprüche 1 bis 3, dadurch gekennzeichnet, daß das Ende des ersten zentralen Leiters (9) einen Eingang für das Signal der Frequenz $f_{OL}$ bildet, wobei das auf der Seite der Schlitzleitung liegende Ende des zweiten zentralen Leiters (200) einen Eingang für das Signal der Frequenz $f_S$ und einen Ausgang für die Frequenz $f_{FI}$ bildet ; wobei ferner die Dioden des ersten Paares (15, 16) gleichsinnig geschaltet sind und die Anode der ersten Diode mit der ersten Masseebene (21) verbunden ist, während die Dioden des zweiten Paares (17, 18) gleichsinnig geschaltet sind und die Kathode der zweiten Diode mit der zweiten Masseebene (22) verbunden ist, und daß ein Kurzschluß (131), der im Abstand $d_2 = (\lambda_S + \lambda_{FI})/8$ von den Dioden angeordnet ist, die erste (21) und die zweite (22) Masseebene direkt mit dem zweiten zentralen Leiter (20) verbindet.

# FIG_1-a

# FIG_1-b

# FIG_2

# FIG_3

# FIG_4

FIG_5

# FIG_6

# FIG_7

4